# EUROPEAN PATENT APPLICATION

(11) **EP 2 573 821 A1**
(43) Date of publication of application: **27.03.2013**
(21) Application number: 10851770.7
(22) Date of filing: 21.05.2010
(51) Int. Cl.: H01L 31/04

(54) **THIN FILM SOLAR CELL**

(71) Applicant: Fuji Electric Co. Ltd., Kanagawa 210-9530 (JP)
(72) Inventor: SHIMOSAWA, Makoto, Kawasaki-shi, Kanagawa 210-9530 (JP); MASUDA, Nobuyuki, Kawasaki-shi, Kanagawa 210-9530 (JP)
(74) Representative: Appelt, Christian W.
(86) International application number: PCT/JP2010/058612
(87) International publication number: WO 2011/145206

(57) **Abstract**

An object of the present invention is to improve the conversion efficiency of a thin film photovoltaic having a structure in which a plurality of unit photovoltaic cells are connected in series by optimizing the placement of collector apertures in each of the unit photovoltaic cells.

A thin film photovoltaic 10 includes a plurality of unit photovoltaic cells (UC) each having a photoelectric conversion section 15 stacked on a front side of an insulating substrate 11 and a back electrode layer 18 stacked on a reverse side of the insulating substrate 11, the plurality of unit photovoltaic cells (UC) being connected in series through a plurality of collector apertures 19 and connection apertures 20. The plurality of collector apertures 19 are placed in such a manner that the collector apertures 19 are distributed in an overlap region A in which the photoelectric conversion section 15 and the back electrode layer 18 which form each of the unit photovoltaic cells (UC) are opposed to each other across the insulating substrate 11 while those collector apertures 19 which are placed most closely to each other are equally spaced from each other.

## Description

### TECHNICAL FIELD

The present invention relates to a photovoltaic configured to generate electric power by utilizing solar light, and more particularly to a thin film photovoltaic having a structure in which a plurality of unit photovoltaic cells (unit cells) are connected in series.

### BACKGROUND ART

In recent years, attention has been focused on photovoltaics as means for solving global environmental problems. Particularly from the viewpoint of reduction in the cost of photovoltaics, attention has been paid to a photovoltaic having a photoelectric conversion layer comprising amorphous silicon, microcrystalline silicon, a compound such as CdTe (cadmium telluride) or CIGS (copper-indium-gallium-selenium), or an organic material because such a photoelectric conversion layer can be formed of a thin film having a thickness of the order of several hundred nm to several µm and, hence, the photovoltaic can substantially reduce the amount of material to be used therein as compared to a conventional photovoltaic. Such a photovoltaic is called a "thin film photovoltaic". One advantage of the thin film photovoltaic is that the thin film photovoltaic can be formed on various types of substrates unlike a conventional crystalline silicon photovoltaic.

Because the voltage generated by a single photovoltaic is low, it is a general practice to adopt a structure for raising the generated voltage by connecting a plurality of unit photovoltaic cells (unit cells) in series. In the case of the thin film photovoltaic, the series connection structure of unit cells is often realized by forming an electrode layer and a photoelectric conversion layer on a single substrate and dividing the layers thus formed into a plurality of unit cells by laser patterning or the like. For example, Patent Document 1 describes a thin film photovoltaic having a structure constructed by forming a plurality of unit cells on a sheet (film) substrate and connecting the unit cells in series by utilizing collector apertures and connection apertures which extend through the sheet (film) substrate. Such a photovoltaic structure is called an "SCAF (Series-Connection through Apertures formed on Film) structure".

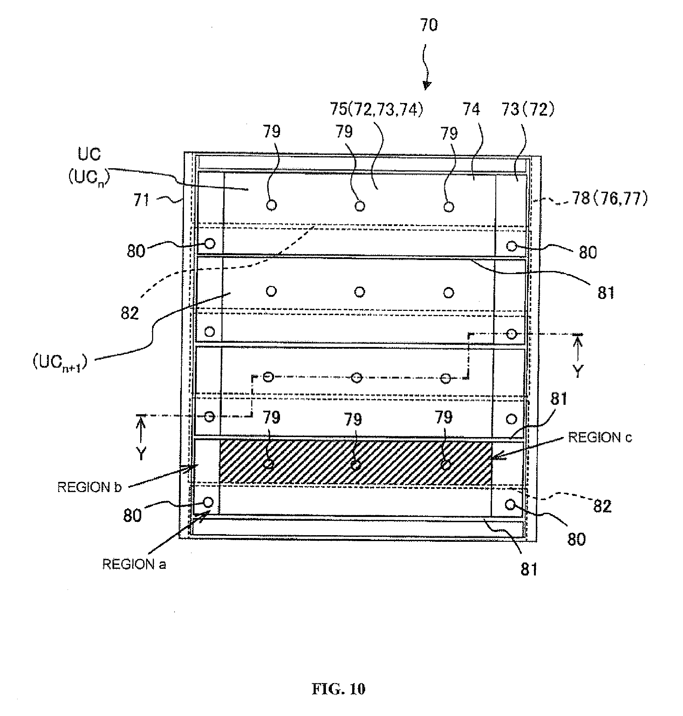

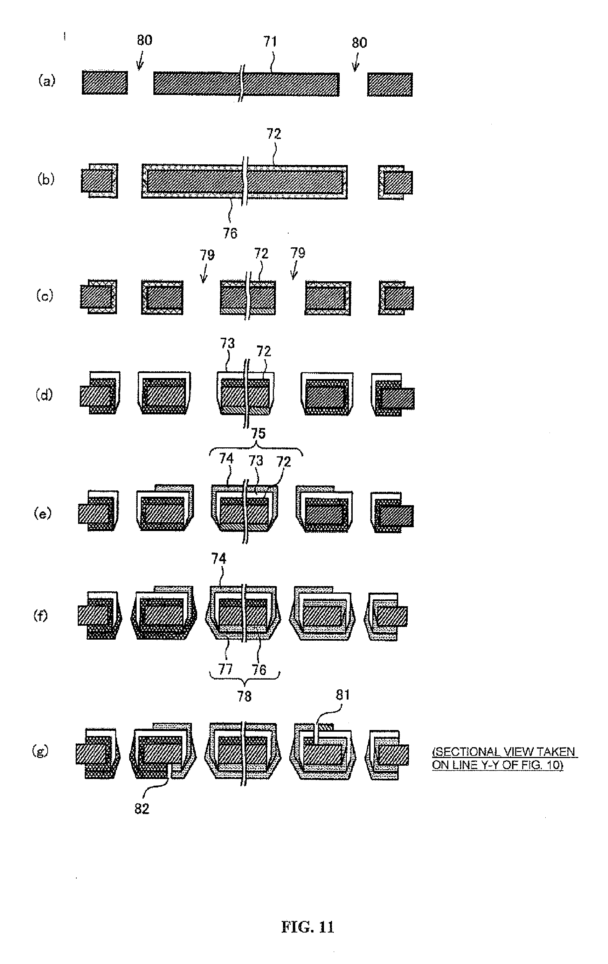

FIG. 10 is a plan view illustrating a conventional thin film photovoltaic having the SCAF structure, and FIG. 11 is a sectional view (corresponding to a sectional view taken on line Y-Y of FIG. 10) illustrating a method of fabricating the conventional thin film photovoltaic having the SCAF structure step by step. In FIG. 11, electrode layers which assume the same potential when the thin film photovoltaic generates electric power by irradiation with light are given the same hatching.
As shown in FIGS. 10 and 11, the thin film photovoltaic 70 includes an insulating substrate 71 having a front side on which a photoelectric conversion section 75 is formed by stacking a first electrode layer 72, a photoelectric conversion layer 73 and a second electrode layer 74 sequentially and a reverse side on which a back electrode layer 78 is formed by stacking a third electrode layer 76 and a fourth electrode layer 77 sequentially. In this example, the first electrode layer 72 and the photoelectric conversion layer 73 are stacked over the same region on the front side of the insulating substrate 71, while the third electrode layer 76 and the fourth electrode layer 77 stacked over the same region on the reverse side of the insulating substrate 71. In FIG. 10, transversely opposite end regions on the front side of the insulating film 71 are each formed with a portion comprising a double-layered structure having the first electrode layer 72 and the photoelectric conversion layer 73, while the central region exclusive of the double-layered structure portions is wholly formed with the photoelectric conversion section 75 comprising a triple-layered structure having the first electrode layer 72, photoelectric conversion layer 73 and second electrode layer 74 by stacking the second electrode layer 74 over the photoelectric conversion layer 73.
The stacks of layers on the front and reverse sides of the insulating substrate 71 are each divided into plural segments by being removed linearly, to form a plurality of unit cells (UC) on the insulating substrate 71 each having the photoelectric conversion section 75 and the back electrode layer 78.
In each of the unit cells (UC), the second electrode layer 74 and the back electrode 78 (including the third electrode layer 76 and the fourth electrode layer 77) are electrically connected to each other through collector apertures 79. Of two adjacent unit cells (represented by UCₙ and UC ₙ₊₁), one unit cell (UCₙ) has an extension of the first electrode layer 72 electrically connected to an extension of the back electrode layer 78 of the other unit cell (UCₙ₊₁) through a connection aperture 80.

With reference to FIG. 11, description will be made of a method of fabricating the conventional thin film photovoltaic step by step.
Initially, as shown in FIG. 11(a), a plurality of connection apertures 80 are formed at plural predetermined locations on the insulating substrate 71. Examples of usable materials for the insulating substrate 71 include polyimide films, polyethylene naphthalate (PEN) films, polyethersulfone films (PES), polyethylene terephthalate (PET) films, and aramid films. Each of the connection apertures 80 is shaped circular having a diameter of the order of 1 mm. The connection apertures 80 can be formed by mechanical means such as a punch.
Subsequently, as shown in FIG. 11(b), the first electrode layer 72 is formed on the front side of the insulating substrate 71, followed by formation of the third electrode layer 76 on the reverse side of the insulating substrate 71. At that time, the first electrode layer 72 and the third electrode layer 76 overlap each other on the inner periphery of each connection aperture 80 to provide electrical continuity therebetween.
Subsequently, as shown in FIG. 11 (c),a plurality of collector apertures 79 are formed on the insulating substrate 71. Like the connection apertures 80, the collector apertures 79 are each shaped circular having a diameter of the order of 1 mm and can be formed by mechanical means such as a punch.

Subsequently, as shown in FIG. 11 (d), the photoelectric conversion layer 73 is formed over the first electrode layer 72. The photoelectric conversion layer 73 is a thin film semiconductor layer which can be formed of an amorphous silicon (a-Si) film for example.
Subsequently, as shown in FIG. 11(e), the second electrode layer 74 is formed over the photoelectric conversion layer 73. The second electrode layer 74 is a transparent electrode layer which can be formed of an indium tin oxide (ITO) film for example. During the formation of the second electrode layer 74, the connection apertures 80 and peripheral regions thereof are covered with a mask or the like to prevent the second electrode layer 74 from being deposited thereon.

Subsequently, as shown in FIG. 11(f), the fourth electrode layer 77 is formed over the third electrode layer 76 formed on the reverse side of the insulating substrate 71. The fourth electrode layer 77 is an electrically conductive layer of low resistance which can be formed of a metal film for example. At that time, the second electrode layer 74 and the fourth electrode layer 77 overlap each other on the inner periphery of each collector aperture 79 to provide electrical continuity therebetween.
By the process steps described above, the photoelectric conversion section 75 comprising a stack of the first electrode layer 72, photoelectric conversion layer 73 and second electrode layer 74 is formed on the front side of the insulating substrate 71, while the back electrode layer 78 comprising a stack of the third electrode layer 76 and fourth electrode layer 77 is formed on the reverse side of the insulating substrate 71.

Subsequently, as shown in FIG. 11(g) , the stack of layers on the front side of the insulating substrate 71 is removed linearly to form a first line-like removed portion 81, while the stack of layers on the reverse side of the insulating substrate 71 is removed linearly to form a second line-like removed portion 82. In this way, the plurality of unit cells (UC) each having the photoelectric conversion section 75 stacked on the front side of the insulating substrate 71 and the back electrode layer 78 stacked on the reverse side of the insulating substrate 71 are formed on the insulating substrate 71. As described above, the second electrode layer 74 and the fourth electrode layer 77 (i.e., back electrode layer 78) in each unit cell (UC) are electrically connected to each other through the collector apertures 79, while the first electrode layer 72 of one unit cell (UCₙ) of two adjacent unit cells (UCₙ and UC ₙ₊₁) has the extension electrically connected to the extension of the third electrode layer 76 (i.e., back electrode layer 78) of the other unit cell (UCₙ₊₁) through the connection apertures 80.

When carriers (electrons and positive holes) are generated in the photoelectric conversion layer 73 of each unit cell (UC) by irradiation of the thin film photovoltaic 70 with light, an electric field in the pn junction causes carriers of one type to flow toward the second electrode layer (i.e., transparent electrode layer) 74. Since the second electrode layer 74 has electrical continuity with the fourth electrode layer 77 (i.e., back electrode 78) through the inner periphery of each collector aperture 79, the carriers having flowed into the second electrode layer 74 travel toward the reverse side of the insulating substrate 71 through the collector apertures 79. Because the photoelectric conversion layer 73 can be regarded virtually as an insulating layer, the first electrode layer 72 and the second electrode layer 74 are insulated from each other virtually. The carriers having traveled to the reverse side of the insulating substrate 71 travel directly to each connection aperture 80. The second electrode layer 74 is absent in the regions in which the connection apertures 80 are formed and, hence, the first electrode layer 72 and the third electrode layer 76 (i.e. back electrode layer 78) have electrical continuity therebetween through the inner periphery of each connection hole 80. Therefore, the carriers travel to reach the front side of the insulating substrate 71 again through the connection apertures 80. Thereafter, the carriers travel on the front side of the insulating substrate 71 toward the photoelectric conversion layer 73 of an adjacent unit cell (UC). Thus, the conventional thin film photovoltaic 70 having the SCAF structure has a structure in which the plurality of unit cells (UCs) are connected in series through the collector apertures 79 and the connection apertures 80.

Patent Document 1 : Japanese Patent Application Laid-open No. H10-233517

In the conventional thin film photovoltaic described above, each of the unit cells has the second electrode layer as the transparent electrode layer and the back electrode layer which are electrically connected to each other through the collector apertures and, hence, a power loss (i.e., collection loss) at the transparent electrode layer of high resistance is reduced to a certain extent.

However, absolutely no study has been made on how to place the collector apertures in the above-described conventional thin film photovoltaic. For this reason, the distance over which the carriers generated in a unit photoelectric conversion section have to travel in the transparent electrode layer of high resistance up to each collector aperture is long enough to leave the collection loss still large. Because the placement of the collector apertures is considered to exercise an effect on the output characteristics of a thin film photovoltaic, it is desired to optimize the placement as far as possible.

### DISCLOSURE OF THE INVENTION

The present invention has been made in view of such challenges. Accordingly, an object of the present invention is to provide a thin film photovoltaic having a structure including a plurality of unit photovoltaic cells connected in series which allows the conversion efficiency thereof to be improved as compared to the conventional thin film photovoltaic by optimizing the placement of the collector apertures.

A thin film photovoltaic according to one aspect of the present invention includes a plurality of unit photovoltaic cells each having a photoelectric conversion section in which a first electrode layer, a photoelectric conversion layer and a transparent second electrode layer are stacked sequentially on a front side of an insulating substrate, and a back electrode layer stacked on a reverse side of the insulating substrate, the unit photovoltaic cells being arranged in such a manner that two adjacent unit photovoltaic cells define therebetween a first overlap region in which a portion of the first electrode layer which fails to form the photoelectric conversion section of one of the two adjacent unit photovoltaic cells and a portion of the back electrode layer of the other unit photovoltaic are opposed to each other across the insulating substrate, and the plurality of unit photovoltaic cells being connected in series by an arrangement such that in each of the unit photovoltaic cells, the second electrode layer and the back electrode layer are electrically connected to each other through a plurality of collector apertures extending through the insulating substrate while the first electrode layer of one of the two adjacent unit photovoltaic cells and the back electrode layer of the other unit photovoltaic are electrically connected to each other through at least one connection aperture extending through the insulating substrate in the first overlap region, wherein the plurality of collector apertures are placed in such a manner that the collector apertures are distributed in a second overlap region in which the photoelectric conversion section and the back electrode layer which form each of the unit photovoltaic cells are opposed to each other across the insulating substrate while those collector apertures which are placed most closely to each other are equally spaced from each other.

It was confirmed from a study made by the inventors of the present invention that a thin film photovoltaic having a collector aperture placement in which a plurality of collector apertures are distributed in a target region (i.e., the region which allows the collector apertures to be placed therein) while those collector apertures which are placed most closely to each other are equally spaced from each other generated a higher output power than a thin film photovoltaic having any other collector aperture placement. Therefore, the thin film photovoltaic according to the present invention allows output characteristics (conversion efficiency) thereof to be improved by optimizing the collector aperture placement.

### BRIEF DESCRIPTION OF THE DRAWINGS

FIG. 1 is a plan view schematically illustrating the configuration of a thin film photovoltaic according to one embodiment of the present invention;
FIG. 2 is a sectional view taken on line X-X of FIG. 1 ;
FIG. 3 is a view illustrating a placement of collector apertures in a lattice form;
FIG. 4 is a diagram illustrating the relationship at an aperture ratio of 2% between the row number of collector apertures and the output power (Pmax) of a thin film photovoltaic;
FIG. 5 is a diagram illustrating the relationship at an aperture ratio of 4% between the row number of collector apertures and the output power (Pmax) of a thin film photovoltaic;
FIG. 6 is a diagram illustrating the relationship at an aperture ratio of 1% between the row number of collector apertures and the output power (Pmax) of a thin film photovoltaic;
FIG. 7 is a diagram illustrating the relationship between the collector aperture diameter and the output power (Pmax) of a thin film photovoltaic;
FIG. 8 is a view schematically illustrating a placement of collector apertures in a staggered form;
FIG. 9 is a diagram illustrating the relationship between the row number of collector apertures placed in a staggered form and the output power (Pmax) of a thin film photovoltaic;
FIG. 10 is a plan view of a conventional thin film photovoltaic; and
FIG. 11 is a view, corresponding to a sectional view taken on line Y-Y of FIG. 7, illustrating a method of fabricating the conventional thin film photovoltaic step by step.

### BEST MODE FOR CARRYING OUT THE INVENTION

Hereinafter, embodiments of the present invention will be described with reference to the attached drawings.

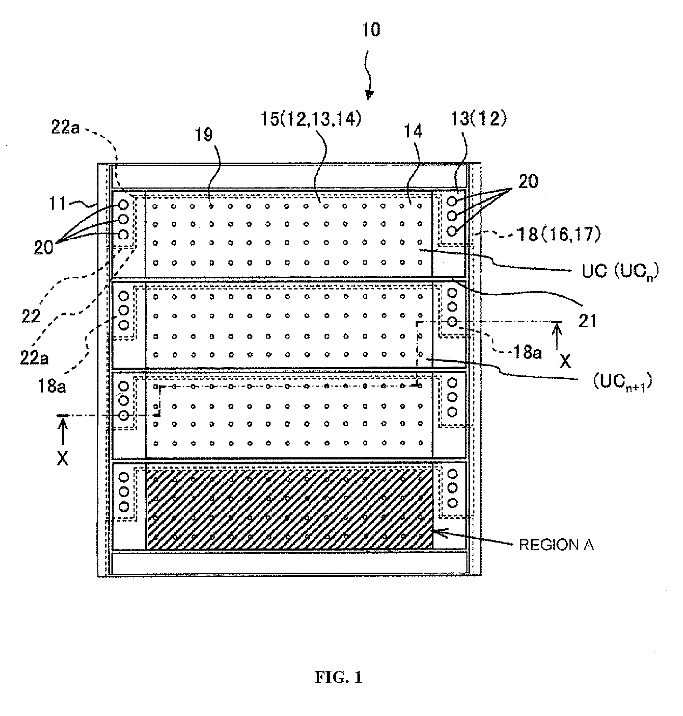

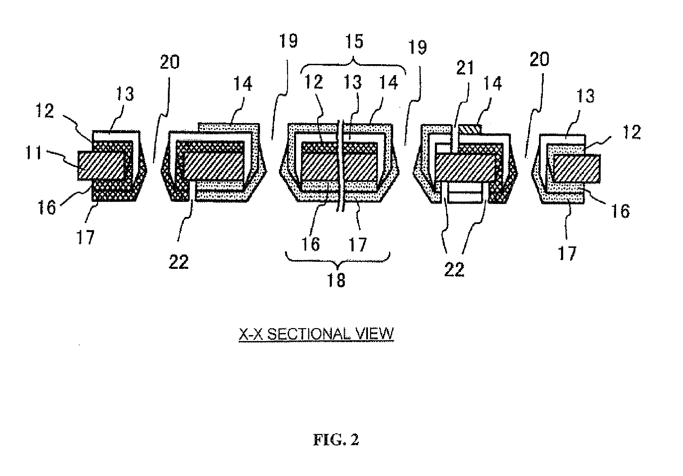

FIG. 1 is a plan view schematically illustrating the configuration of a thin film photovoltaic 10 according to one embodiment of the present invention, and FIG. 2 is a sectional view taken on line X-X of FIG. 1. The thin film photovoltaic 10 according to the present embodiment is of the SCAF structure and has basically the same configuration as the conventional thin film photovoltaic 70 shown in FIGS. 10 and 11. In brief, the thin film photovoltaic 10 includes a flexible insulating substrate 11. The insulating substrate 11 has a front side on which a photoelectric conversion section 15 is formed by stacking a first electrode layer 12, a photoelectric conversion layer 13 and a second electrode layer 14 sequentially and a reverse side on which a back electrode layer 18 is formed by stacking a third electrode layer 16 and a fourth electrode layer 17 sequentially.

The stacks of layers on the front and reverse sides of the insulating substrate 11 are each divided into plural segments by being removed linearly by a laser patterning process for example, to form a plurality of unit photovoltaic cells (unit cells: UC) on the insulating substrate 11, the unit photovoltaic cells each having the photoelectric conversion section 15 stacked on the front side of the insulating substrate 11 and the back electrode layer 18 stacked on the reverse side of the insulating substrate 11. The portions of the stack of layers on the front side of the insulating substrate 11 which are removed linearly (depicted by solid line) are first line-like removed portions 21, while the portions of the stack of layers on the reverse side of the insulating substrate 11 which are removed linearly (depicted by broken line) are second line-like removed portions 22. The shapes of the first and second line-like removed portions 21 and 22 will be described later.

In each of the unit cells (UC), the second electrode layer 14 and the fourth electrode layer 17 are electrically connected to each other through a plurality of collector apertures 19. The first electrode layer 12 of one unit cell (UCₙ) of two adjacent unit cells (UCₙ and UCₙ₊₁₎ has an extension electrically connected to an extension of the third electrode layer 16 of the other unit cell (UCₙ₋₊₁) through connection apertures 20. The thin filmphotovoltaic 10 of this arrangement according to the present embodiment also realizes the structure in which the plurality of unit cells (UC) are connected in series. The extension of the first electrode layer 12 of each unit cell (UC) is meant by that region of the first electrode layer 12 formed on the front side of the substrate which fails to form the photoelectric conversion section 15 (i.e., the region which fails to form a triple-layered structure), or a portion thereof, while the extension of the third electrode layer 16 of each unit cell (UC) is meant by that region of the third electrode layer 16 formed on the reverse side of the substrate which is exclusive of that region of the third electrode layer 16 which is coincident with the photoelectric conversion section 15 on the front side of the substrate, or a portion thereof.
The electrical connection between the first electrode layer 12 of one unit cell (UCₙ) and the third electrode layer 16 of the other unit cell (UCₙ₊₁) through the connection apertures 20 can be expressed otherwise as follows.
The unit cells are arranged in such a manner that two adjacent unit cells define therebetween an overlap region in which a portion of the first electrode layer 12 which fails to form the photoelectric conversion section 15 of one of the two adjacent unit cells and a portion of the third electrode layer 16 of the other unit cell are opposed to each other across the insulating substrate 11 (hereinafter will be referred to as a "first overlap portion") while the first electrode layer 12 of one of the two adjacent unit cells and the third electrode layer 16 of the other unit cell are electrically connected to each other through the connection apertures 20 extending through the insulating substrate 11 in the first overlap region.

Further description is directed to the components of the above-described thin film photovoltaic 10.
The insulating substrate 11 is a plastic substrate for example. Examples of usable materials for such a plastic substrate include polyimide films, polyethylene naphthalate (PEN) films, polyethersulfone films (PES), polyethylene terephthalate (PET) films, and aramid films. The thickness of the insulating substrate 11 is 50 µm for example, which is not limited. In cases where the insulating substrate does not need flexibility, use may be made of a glass substrate or the like.

The first and third electrode layers 12 and 16 are each a layer of silver (Ag) having a thickness of several hundred nm for example, which is formed by a sputtering process. Though not shown, the first electrode layer 12 has a surface which may be imparted with a texture form for increasing the absorption of light at the photoelectric conversion layer 13 by scattering incident light. While the present embodiment uses the silver (Ag) electrode as the first electrode layer 12, there is no limitation to this feature. For example, the first electrode layer 12 may comprise a stacked film formed by depositing titanium dioxide (TiO₂) , which is resistant to plasma, on the surface of a silver (Ag) electrode, a tin dioxide (SnO₂) film, a zinc oxide (ZnO) film, or a like film. Alternatively, a material which can be shaped into an optimal texture form may be used to form the first electrode layer 12.

The photoelectric conversion layer 13 is a thin film semiconductor layer which has a two-layer tandem structure comprising an amorphous silicon (a-Si) layer and an amorphous silicon-germanium (a-SiGe) layer according to the present embodiment. However, there is no limitation to this feature. Other usable materials for the photoelectric conversion layer 13 include amorphous silicon carbide (a-SiC), amorphous silicon oxide (a-SiO), amorphous siliconnitride (a-SiN), microcrystalline silicon (µc-Si), microcrystalline silicon-germanium (µc-SiGe), microcrystalline silicon carbide (µc-SiC), microcrystalline silicon oxide (µc-SiO), microcrystalline silicon nitride (µc-SiN), and a like material. Compound materials and organic materials may also be used. Each of the layers forming the photoelectric conversion layer 13 can be formed by plasma chemical vapor deposition (plasma CVD), sputtering, vapor deposition, catalytic chemical vapor deposition (Cat-CVD), photochemical vapor deposition (photo CVD), or a like process.

The second electrode layer 14 is a transparent electrode layer for which the present embodiment uses an indium tin oxide (ITO) film deposited by sputtering. However, there is no limitation to such an indium tin oxide film, but use may be made of a tin dioxide (SnO₂) film, a zinc oxide (ZnO) film, and a like film.

The fourth electrode layer 17 is a low-resistant conductive film comprising a metal film. The present embodiment uses a nickel (Ni) film deposited by sputtering for the fourth electrode layer 17. However, there is no limitation to such a nickel film, but the fourth electrode layer 17 may be formed by using a material other than nickel.

The collector apertures 19 are placed in such a manner as to be distributed over the entire overlap region in which the photoelectric conversion section 15 and the back electrode layer 18 which form each unit cell (UC) are opposed to each other across the insulating substrate 11 (hereinafter will be referred to as a "second overlap region"). The connection apertures 20 are placed in the above-described first overlap region, and each unit cell (UC) is provided with six connection apertures 20 (three connection apertures on each of the transversely opposite end sides). The collector apertures 19 and the connection apertures 20 are formed by mechanical means such as a punch. In the present embodiment, the collector apertures 19 and the connection apertures 20 are both shaped circular. However, the collector apertures 19 and connection apertures 20 may be appropriately changed in shape, size and number so as to meet the specifications and the like of the thin film photovoltaic 10. The placement of the collector apertures 19 according to the present embodiment (i.e., distributed placement) will be described later.
Amethodof fabricating the thin filmphotovoltaic 10 according to the present embodiment is basically the same as the method of fabricating the conventional thin film photovoltaic shown in FIG. 10 (see FIG. 11) and, for this reason, description thereof is omitted.

Description will be made of some features of the thin film photovoltaic 10 which are characteristic of the present embodiment while making comparison with the conventional thin film photovoltaic (see FIG. 10). Here, description is directed particularly to feature A: the shapes of the first and second line-like removed portions and feature B: the distributed placement of collector apertures.

Feature A: the shapes of the first and second line-like removed portions
As shown in FIG. 10, the conventional thin film photovoltaic 70 is formed with the first and second line-like removed portions 81 and 82 extending like straight lines. Each of the connection apertures 80 is placed in a region a of regions a and b defined in plan view between each first line-like removed portion 81 and an adjacent second line-like removed portion 82. If a collector aperture 79 is placed in the region a, the second electrode layer 74 and the back electrode layer 78 (including the third and fourth electrode layers 76 and 77) provide electrical continuity therebetween through that collector aperture 79 while the first electrode layer 73 and the back electrode layer 78 provide electrical continuity therebetween through the connection aperture 80, so that electrical continuity is provided between the first electrode layer 73 and the second electrode layer 74, thus causing leakage to occur. For this reason, it is necessary for the collector aperture 79 to be placed in the region b which is different from the region a in which the connection aperture 80 is placed. As a result, the region which allows the collector aperture 79 to be placed in the conventional thin film photovoltaic 70 is limited to a region c in which the region b and a unit photoelectric conversion section 75 overlap each other. In this case, the distance over which the carriers generated at a part of the photoelectric conversion section 75 in a region other than the region c, that is, a region near the region a have to travel in the second electrode layer 74 of high resistance up to the collector aperture 79, is long enough to cause a large collection loss.

In the thin film photovoltaic 10 according to the present embodiment, by contrast, each second line-like removed portion 22 is formed to have a bend portion 22a as shown in FIG. 1, though each first line-like removed portion 21 is formed to extend like a straight line as in the conventional thin film photovoltaic. Specifically, each second line-like removed portion 22 according to the present embodiment has a bend structure on each of the transversely opposite sides of FIG. 1, the bend structure being formed to have two 90° bends. This feature is provided for the purpose of expanding the second overlap region which allows the collector apertures 19 to be placed therein as compared with that of the conventional thin film photovoltaic while securing the first overlap region for placement of the connection apertures 20. That is, each second line-like removed portion 22 is bent (to have bend portions 22a) in plan view so as to embrace the region in which the back electrode layer 18 forming each unit cell (UC) and the whole or a major part of the corresponding photoelectric conversion section 15 are opposed to each other across the insulating substrate 11 as well as to secure the first overlap region for placement of connection apertures 20 on each of the transversely opposite sides of FIG. 1.
Stated otherwise, the back electrode layer 18 of each unit cell (UC) has a bend portion defining the first overlap region (i.e., the region for placement of connection apertures 20 therein) on the side near each adjacent unit cell. More specifically, the back electrode 18 partially projects toward the unit cells adjacent thereto to have projecting portions 18a defining the first overlap regions (i.e., the regions for placement of connection apertures 20 therein) on both of the transversely opposite sides of FIG. 1. In each unit cell (UC), the second overlap region which allows the collector apertures 19 to be placed therein is a region A of FIG. 1, namely, the whole or a major part of the photoelectric conversion section 15. For this reason, the thin film photovoltaic 10 according to the present embodiment makes the region which allows the collector apertures 19 to be placed therein larger than that of the conventional thin film photovoltaic, thus allowing a desired number of collector apertures 19 to be placed at desired locations in each unit photoelectric conversion section (i.e., second electrode layer 14) to meet the photovoltaic fabrication conditions and the like. This feature can shorten the distance over which the carriers generated at each unit photoelectric conversion section have to travel in the second electrode layer 74 of high resistance, thereby making it possible to reduce the collection loss.

The shape of each second line-like removed portion 22 is not limited to that in the present embodiment. For example, each second line-like removed portion 22 may be bent not at a right angle but in a slanting direction, or may have a curve which may be folded. The "bend portion", as used in the present embodiment, is meant to include these shapes as well as the shape described in the present embodiment. It is also possible that each first line-like removed portion 21 has a bend portion while each second line-like removed portion 22 formed to extend like a straight line. Alternatively, both the first and second line-like removed portions 21 and 22 may have bend portions.
Simply speaking, in each unit cell (UC) at least one of the first and second line-like removed portions 21 and 22 is formed to have the bend portion so that the whole or a major part of the photoelectric conversion section 15 serves as the second overlap region which allows the collector apertures 19 to be placed therein. As a result, in each unit cell (UC) at least one of the first electrode layer 12 and the back electrode layer 18 is formed to have a bend portion so that the whole or a major part of the photoelectric conversion section 15 is opposed to (or overlaps) the back electrode 18 across the insulating substrate 11.

When each first line-like removed portion 21 or each second line-like removed portion 22 has the bend portion, the bend portion is preferably located within a region around the connection apertures 20 in which the second electrode layer 14 is absent. The "region in which the second electrode layer 14 is absent", as used herein, is meant to include the region on the front side of the insulating substrate 11 in which the second electrode layer 14 is not formed and the region on the reverse side of the insulating substrate 11 which is coincident with the former region. When each first line-like removed portion 21 has the bend portion, the region of concern is the former region, while when each second line-like removed portion 22 has the bend portion, the region of concern is the latter region. By locating the bend portion of each first line-like removed portion 21 or that of each second line-like removed portion 22 in the region in which the second electrode layer 14 is absent, the region which allows the collector apertures 19 to be placed therein (i.e. , the second overlap region) can be expanded.

In the present embodiment, the stacks of layers on the observe and reverse sides of the insulating substrate 11 are removed linearly to form the first and second line-like removed portions 21 and 22, thereby forming the plurality of unit cells (UC) each having the photoelectric conversion section 15 stacked on the front side of the insulating substrate 11 and the back electrode layer 18 stacked on the reverse side of the insulating substrate 11. There is no limitation to this feature. For example, the plurality of unit cells may be formed on the insulating substrate 11 by stacking the layers on the front and reverse sides of the insulating substrate 11 with use of masks. In this case, the regions in which the masks have prevented the layers from being stacked correspond to the first and second line-like removed portions 21 and 22.

Feature B: the distributed placement of collector apertures
In order to study an optimal placement of the collector apertures, a simulation on the output characteristics of a thin film photovoltaic was carried out with an area loss and a collection loss taken into consideration. The "area loss", as used herein, is meant by a decrease in generated current corresponding to a decrease in power generating area which is caused by the presence of the collector apertures (i.e., a decrease corresponding to the total area of the collector apertures). The "collection loss", as used herein, is meant by a power loss which is incurred when the carriers generated at the photoelectric conversion section travel in the second electrode layer (i.e., transparent electrode layer) and/or when the carriers pass through the collector apertures. Factors which are considered to exercise particular effects on the collection loss include the placement and size of the collector apertures, the sheet resistance of the second electrode layer, and the like. The simulation was carried out using a finite element method. A voltage drop was calculated by analysis of current in each of mesh regions to derive the current-voltage characteristics (IV characteristics) of the thin film photovoltaic. The region which allows the collector apertures to be placed therein is the second overlap region in which the photoelectric conversion section and the back electrode layer which form each unit cell are opposed to each other across the insulating substrate and which corresponds to the region A (rectangular region) in FIG. 1. The characteristics were checked under some conditions by using actually fabricated thin film photovoltaics each having the SCAF structure.

Initially, a study was conducted on the row number of collector apertures placed in the region A.
Specifically, the output powers of thin film photovoltaics were compared to each other by varying the row number of collector apertures while keeping constant the ratio of the total aperture area of the collector apertures to the whole area of a unit photoelectric conversion section (i.e., power generating region) (hereinafter will be referred to as the "aperture ratio"). In the following description, the direction along the long side of the region A is referred to as "X-direction", while the direction along the short side of the region A referred to as "Y-direction". The "the row number", as mentioned above, is equal to the number of collector apertures aligned in the Y-direction.

When the aperture ratio is constant, the area loss remains substantially the same and, therefore, the output power difference (i.e., the difference in conversion efficiency) between the thin film photovoltaics depends on how to place the collector apertures. In the present study, the output powers of the thin film photovoltaics were compared to each other by varying the row number of collector apertures with three aperture ratios (1%, 2% and 4%) used. Each of the aperture ratios was realized by adjusting the number of collector apertures while fixing the diameter of each collector aperture to 1 mm. In the present study, the output powers (Pmax) of the thin film photovoltaics were calculated under the conditions: the size of the region A allowing the collector apertures to be placed therein (rectangular region) = 195.6 mm (X) × 26.8 (Y) mm; and the sheet resistance of the second electrode layer = 20 Q, 50 Ω and 100 Ω for each of the aperture ratios.

Specifically, a plurality of collector apertures were placed in the region A according to the following process steps (1) to (4) and the output powers (Pmax) of the thin film photovoltaics were calculated with the collector apertures in different placements.
In step (1), the row number n of collector apertures is determined and the region A is divided into (n+1) regions in the Y-direction. For example, when five rows of collector apertures are to be placed, it follows that 26.8/(5+1) = 4.47. Therefore, five division lines in parallel with the long side of the region A (hereinafter will be referred to as "first division lines") are drawn at intervals of 4.47 mm in the Y-direction to divide the region A into six regions. Thus, six rectangular regions each sized 195.6 mm × 4.47 mm are formed in the region A.

In step (2), the number of collector apertures forming each row is determined. Here, the total number of collector apertures is determined in accordance with the aperture ratio and the number of collector apertures forming each row is determined by dividing the total number thus determined by the row number n. For example, when five rows of collector apertures are to be placed with the aperture ratio set to 2%, the 2% aperture ratio corresponds to about 130 collector apertures (1 mmφ) formed in the region A and, hence, the number of collector apertures forming each row is 130/5 = 26. In the present study, when the value obtained by dividing the total number of collector apertures by the row number n was not an integer, the total number of collector aperture was adjusted to obtain an integer which is closest to the value calculated.

In step (3), the region A is divided into {the number of collector apertures forming each row determined in step (2) +1) } in the X-direction. For example, when five rows of collector apertures are to be placed with the aperture ratio set to 2%, it follows that 195. 6/ (26+1) = 7.24. Therefore, 26 division lines in parallel with the short side of the region A (hereinafter will be referred to as "second division lines") are drawn at intervals of 7.24 mm in the X-direction to divide the region A into 27 regions. As a result, the region A is divided in a lattice form by the first and second division lines to form 162 (= 6 × 27) rectangular regions each sized 7.24 mm × 4.47 mm in the region A.

In step (4), the collector apertures are placed in such a manner that their respective centers coincide with the points of intersection of the first division lines and the second division lines (i.e., lattice points).
By the steps (1) to (4), the collector apertures, the number of which realizes a predetermined aperture ratio, are placed in a lattice form in the region A. By this placement, the predetermined number of collector apertures are distributed in the region A, or placed all over the region A, while the plurality of collector apertures thus placed are equally spaced from each other in the X-direction and in the Y-direction. Note that the regions resulting from the division by the steps (1) to (3) are different from mesh regions used in the infinite element method.

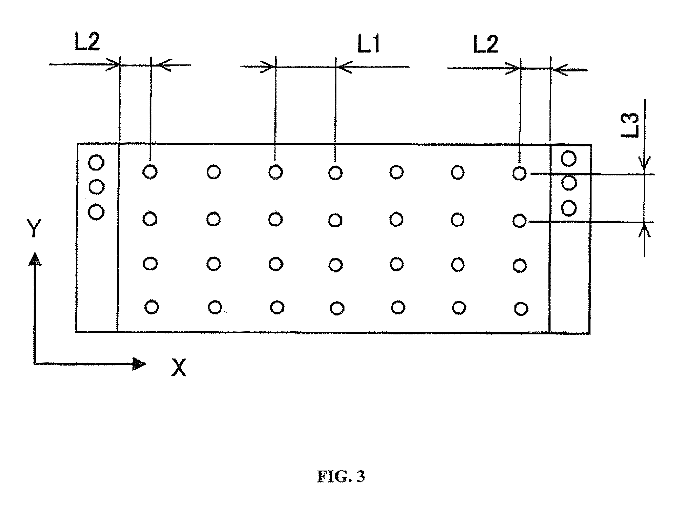

FIG. 3 is a view schematically illustrating a placement of plural collector apertures in a lattice form (row number = 4). In the lattice-form placement shown in FIG. 3, the positions of all the collector apertures in the X-direction are adjusted so that the distance (L2) in the X-direction from each of the opposite ends of a unit photoelectric conversion section (i.e., power generating region) to those collector apertures which are located most closely thereto is as large as about 1/2 of the distance (L1) in the X-direction between those collector apertures which are located most closely to each other.

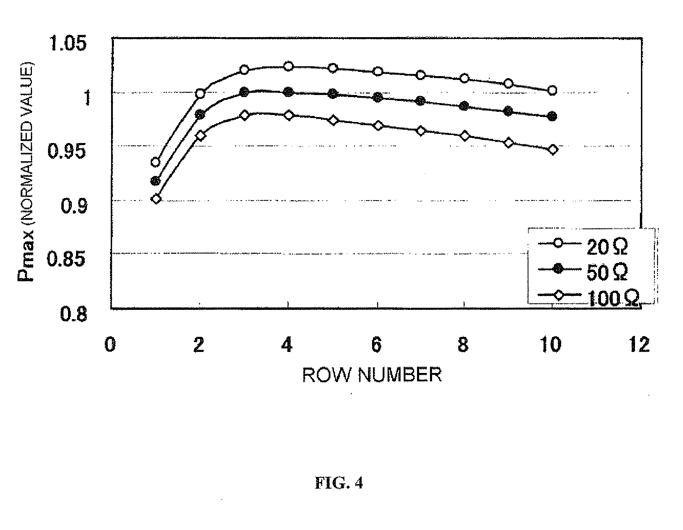

FIG. 4 illustrates the relationship at an aperture ratio of 2% between the row number of collector apertures and the output power (Pmax) of a thin film photovoltaic calculated. The output power (Pmax) in FIG. 4 is normalized to assume a value of 1.0 under the conditions: the row number of collector apertures = 4; and the sheet resistance of the second electrode layer = 50 Ω.
As can be seen from FIG. 4, in the case of 2% aperture ratio the output power (Pmax) of the thin film photovoltaic assumes the highest value at any one of the sheet resistances when the row number of collector apertures is 3 to 4. Moreover, the output power of the thin film photovoltaic lowers as the sheet resistance of the second electrode layer increases.

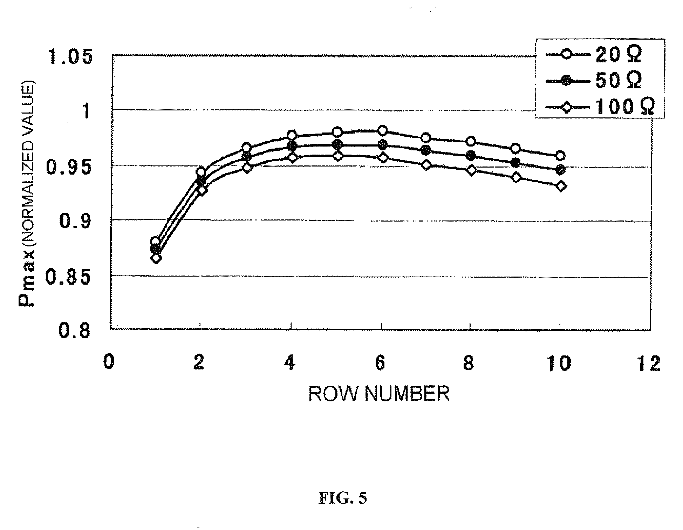

FIG. 5 illustrates the relationship at an aperture ratio of 4% between the row number of collector apertures and the output power (Pmax) of a thin film photovoltaic calculated. As in FIG. 4, the output power (Pmax) in FIG. 5 is normalized to assume a value of 1.0 under the conditions: the aperture ratio = 2%; the row number of collector apertures = 4; and the sheet resistance of the second electrode layer = 50 Ω.
As can be seen from FIG. 5, in the case of 4% aperture ratio the output power (Pmax) assumes the highest value at any one of the sheet resistances when the row number of collector apertures is 5 to 6 and, hence, the row number of collector apertures with which the thin film photovoltaic generates the highest output power (Pmax) is increased as compared with the case of 2% aperture ratio (see FIG. 3). As can also be seen, the range of change in the output power of the thin film photovoltaic with change in the sheet resistance of the second electrode layer is reduced as compared with the case of 2% aperture ratio.

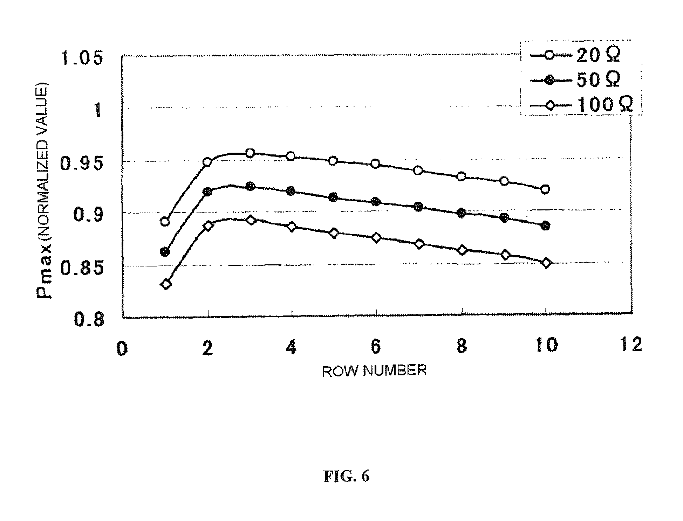

FIG. 6 illustrates the relationship at an aperture ratio of 1% between the row number of collector apertures and the output power (Pmax) of a thin film photovoltaic calculated. As in FIGS. 4 and 5, the output power (Pmax) in FIG. 6 is normalized to assume a value of 1.0 under the conditions: the aperture ratio = 2%; the row number of collector apertures = 4; and the sheet resistance of the second electrode layer = 50 Ω.
As can be seen from FIG. 6, in the case of 1% aperture ratio the output power (Pmax) assumes the highest value at any one of the sheet resistances when the row number of collector apertures is 2 to 3 and, hence, the row number of collector apertures with which the thin film photovoltaic generates the highest output power (Pmax) is decreased as compared with the case of 2% aperture ratio (see FIG. 4). As can also be seen, the range of change in the output power of the thin film photovoltaic with change in the sheet resistance of the second electrode layer is increased as compared with the case of 2% aperture ratio.

It can be confirmed from FIGS. 4 to 6 that as the aperture ratio increases, the row number of collector apertures with which the thin film photovoltaic generates the highest output power (Pmax) shifts toward a higher row number while the range of change in the output power of the thin film photovoltaic with change in the sheet resistance of the second electrode layer decreases.

With respect to the spacing between collector apertures, it was confirmed that in the case of the row number of collector apertures with which the thin f ilmphotovoltaic generated the highest output power (Pmax) at each aperture ratio, the spacing between the collector apertures aligned in the X-direction was substantially equal to that between the collector apertures aligned in the Y-direction. This means that the output power (Pmax) of the thin film photovoltaic becomes highest at any one of the aperture ratios when the plurality of collector apertures are placed in such a manner that the collector apertures are distributed all over the region A while the spacing between the collector apertures aligned in the X-direction and that between the collector apertures aligned in the Y-direction are substantially equal to each other, that is, L1 = L3 in FIG. 3.
Stated otherwise, though the optimal row number of collector apertures differs according to the aperture ratio (i.e., the number of collector apertures), all the cases share the feature that at any one of the aperture ratios the plurality of collector apertures are preferably placed in such a manner that the collector apertures are distributed in the overlap region in which the unit photoelectric conversion section and the unit back electrode section which form each unit cell overlap each other while those collector apertures which are located most closely to each other are equally spaced from each other.

The range of change in the output power of the thin film photovoltaic with change in sheet resistance is considered as follows. As the aperture ratio increases, the number of collector apertures placed in the region A increases and, hence, the spacing between the collector apertures becomes relatively small. This makes the current collecting area per collector aperture decrease, so that the output power of the thin film photovoltaic becomes less susceptible to the sheet resistance of the second electrode layer. Therefore, the range of change in output power with change in the sheet resistance of the second electrode layer decreases with increasing aperture ratio. Within the sheet resistance range from 20 Ω to 100 Ω, however, the row number of collector apertures with which the thin film photovoltaic generates the highest output power (Pmax) remains substantially the same at each aperture ratio, as can be seen from FIGS. 4 to 6.
Thus, it can be said that at any one of the sheet resistances the plurality of collector apertures are preferably placed in such a manner that the collector apertures are distributed in the overlap region in which the unit photoelectric conversion section and the unit back electrode section which form each unit cell overlap each other while those collector apertures which are located most closely to each other are equally spaced from each other. Such a second electrode layer having a sheet resistance ranging from 20 Ω to 100 Ω is often used in an actual thin film photovoltaic. Though FIGS. 4 to 6 illustrate the cases where the sheet resistance of the second electrode layer ranges from 20 Ω to 100 Ω, calculation on the collector aperture placement was performed using other resistance value falling out of that sheet resistance range and, as a result, the calculation was confirmed to obtain substantially the same result as the present study with respect to the placement of the collector apertures for which the output power exhibits the highest value (Pmax).

Thus, irrespective of the aperture ratio (the number of collector apertures) and the sheet resistance of the second electrode layer it is preferable that the plurality of collector apertures are placed in such a manner that the collector apertures are distributed in the region A (i.e., the region allowing the collector apertures to be placed therein) while those collector apertures which are located most closely to each other are equally spaced from each other. Such a placement enables the conversion efficiency of the thin film photovoltaic to be improved.
Thin film photovoltaics were actually fabricated under some of the above-described conditions and then comparison as to output characteristics was made between these thin film photovoltaics. It was confirmed from the comparison that substantially the same result as the result of the above-described simulation was obtained.

According to comparisons between FIGS. 4 to 6, when the aperture ratio is 2% in the aperture ratio range from 1% to 4%, the thin film photovoltaic generates the highest output power (Pmax). Therefore, it can also be said to be preferable that the thin film photovoltaic 10 according to the present embodiment, which has substantially the same specifications as the thin film photovoltaic subjected to the present study, has an aperture ratio of about 2%. However, the optimal aperture ratio may vary depending on the sheet resistance of the second electrode layer and a like factor. For this reason, it is preferable to establish the aperture ratio after having conducted a study similar to the present study under varied conditions (e.g., in sheet resistance) that are different from those used in the present study.

Next, a study was carried out on the collector aperture diameter.
Specifically, comparison was made between the output powers of thin film photovoltaics by varying the collector aperture diameter. A simulation was conducted using a placement of collector apertures having a row number of four at 2% aperture ratio (FIG. 4).

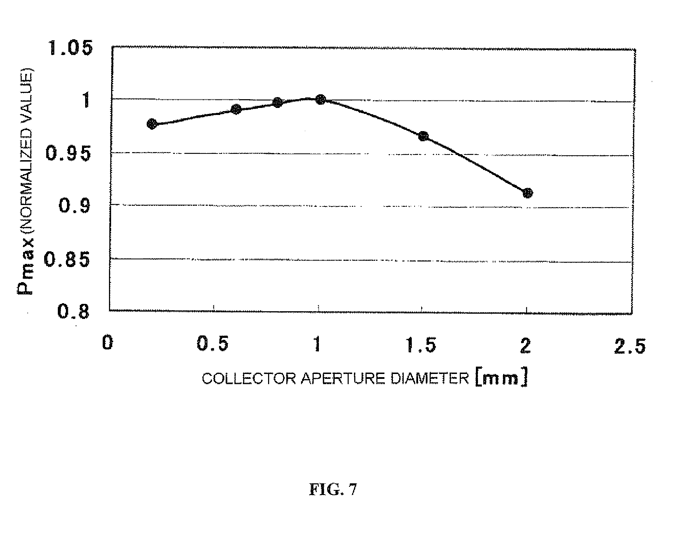

FIG. 7 illustrates the relationship between the diameter of each collector aperture and the output power (Pmax) of a thin film photovoltaic. As in FIGS. 4 to 6, the output power (Pmax) in FIG. 7 is normalized to assume a value of 1.0 under the conditions: the aperture ratio = 2%; the row number of collector apertures = 4; and the sheet resistance of the second electrode layer = 50 Ω.
As can be seen from FIG. 7, the output power (Pmax) of the thin film photovoltaic assumes the highest value when the collector aperture diameter is 1.0 mm. The area loss increases as each collector aperture becomes larger, while the resistance at the collector apertures increases as each collector aperture becomes smaller (i.e., as the circumference of each collector aperture becomes shorter). It can be considered from this fact that when the collector aperture diameter is more than 1 mm, the effect of the area loss becomes predominant, which causes the output power (Pmax) to lower, while when the collector aperture diameter is less than 1 mm, the resistance loss at the collector apertures becomes predominant, which causes the output power (Pmax) to lower.

In FIG. 7, the output power (Pmax) of the thin film photovoltaic can be said to be sufficiently high (Pmax of not less than 0.99) when the collector aperture diameter falls within the range from 0.6 mm to 1.0 mm. When the collector aperture diameter is more than 1 mm, on the other hand, the range of change in the output power of the thin film photovoltaic with change in collector aperture diameter becomes larger. Therefore, it is also preferable that the collector aperture diameter is set to fall within the range from 0.6 mm to 1.0 mm (preferably 1.0 mm) for the thin filmphotovoltaic 10 according to the present embodiment which has substantially the same specifications as the thin film photovoltaic subjected to the present study.

Meanwhile, the second electrode layer (i.e., transparent electrode layer) and the fourth electrode layer overlap each other on the inner periphery of each collector aperture to provide electrical continuity therebetween. Since the second electrode layer has a high resistance inherently, the sheet resistance of the fourth electrode is considered to be predominant over the resistance change at the collector apertures. Therefore, even when the collector aperture diameter remains the same, the resistance at the collector apertures changes if the material or the thickness of the fourth electrode layer is changed. Though the resistance at the collector apertures (1 mmφ) was about 0.8 Ω according to the present study, it is possible that the optimal collector aperture diameter shifts toward a lower value when the resistance at the collector apertures is decreased by, for example, changing the material for the fourth electrode layer or increasing the film thickness of the fourth electrode layer. It is alsopossible that the optimal collector aperture diameter shifts toward a still lower value because the amount of current collected by each collector aperture decreases as the number of collector apertures increases and, hence, the resistance loss at the collector apertures decreases relatively. Even in such a case, the optimal collector aperture diameter is not considered to become far beyond the above-mentioned range from 0.6 mm to 1 mm. However, a study similar to the present study may be conducted to find out a smaller optimal aperture diameter.

A study was conducted on the above-described collector aperture placing method by using different collector aperture diameters. As a result, it was confirmed that the collector aperture diameter exercised no effect on the optimal placement of the collector apertures because at any one of the collector aperture diameters the output power (Pmax) of the thin film photovoltaic assumed the highest value when the plurality of collector apertures were placed in such a manner that the collector apertures were distributed in the region A while those collector apertures which were located most closely to each other were equally spaced from each other. Thin film photovoltaics were actually fabricated and then an experiment was for comparison as to the collector aperture diameter between these thin film photovoltaics. It was confirmed from the experiment that the same result as the result of the above-described simulation was obtained.

A study was made on a staggered placement of plural collector apertures as a variation of the above-described placement of the plurality of collector apertures (i.e., lattice-form placement).
Specifically, in contrast to the lattice-form placement of collector apertures subjected to each of the above-described studies (FIGS. 4 to 7), the collector apertures were arranged in a staggered placement in which the collector apertures forming each even-numbered row (or each odd-numbered row) were displaced in the X-direction in such a manner that each of the collector apertures forming each even-numbered row (or each odd-numbered row) was positioned on the center of gravity of a minimum quadrangle defined by four collector apertures forming part of odd-number rows.

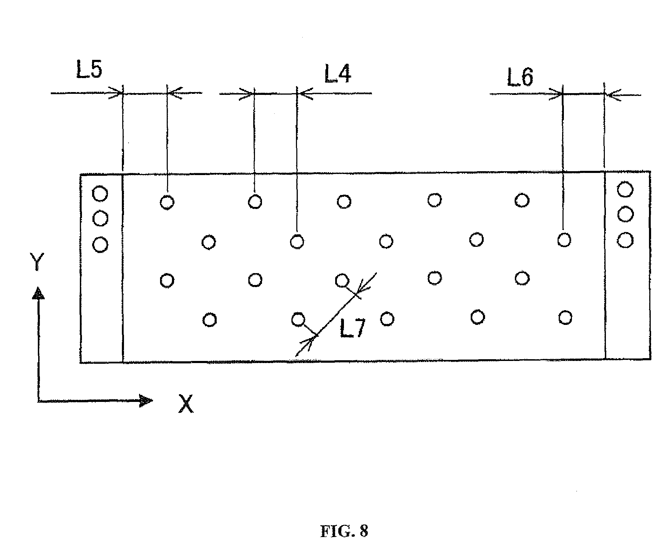

FIG. 8 is a view schematically illustrating a staggered placement of plural collector apertures (row number = 4). In the staggered placement shown in FIG. 8, the positions of all the collector apertures in the X-direction are adjusted so that the distance (L4) in the X-direction between those collector apertures which are located most closely to each other is substantially equal to the distance (L5 or L6) in the X-direction from each of the opposite ends of a unit photoelectric conversion section (i.e., power generating region) to those collector apertures which are located most closely thereto.

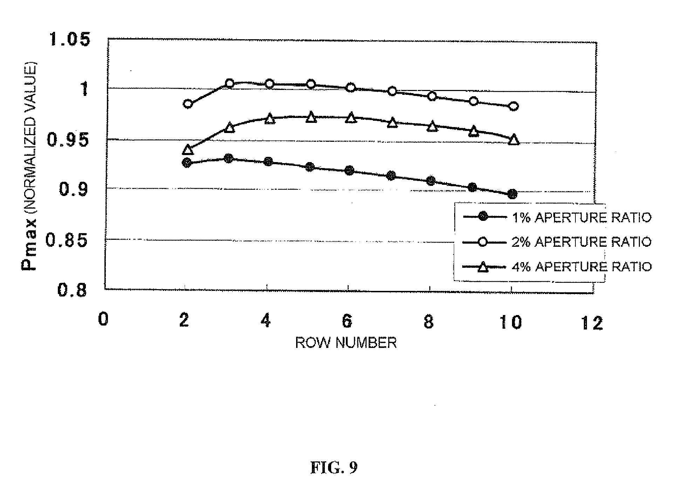

FIG. 9 illustrates the relationship between the row number of collector apertures arranged in a staggered placement and the output power (Pmax) of a thin film photovoltaic. FIG. 9 excerpts only the cases where the collector aperture diameter is 1 mm and the sheet resistance of the second electrode layer is 50 Ω. As in FIGS. 4 to 7, the output power (Pmax) in FIG. 9 is normalized to assume a value of 1.0 under the conditions: the aperture ratio = 2%; the row number of collector apertures = 4; and the sheet resistance of the second electrode layer = 50 Ω.
It was confirmed that with any one of the row numbers the output power (Pmax) of the thin film photovoltaic was enhanced by changing the placement of collector apertures from the lattice-form placement to the staggered placement, as can be seen from FIG. 9. As in the case of the lattice-form placement, it was also confirmed that with the row number of collector apertures with which the output power (Pmax) of the thin film photovoltaic assumed the highest value at each aperture ratio, those collector apertures which were located most closely to each other were substantially equally spaced from each other (L7 in FIG. 8). Thin film photovoltaics were actually fabricated and then an experiment on the staggered placement of collector apertures was conducted for comparison between these thin film photovoltaics. It was confirmed from the experiment that the same result as the result of the above-described simulation was obtained.

It was confirmed by the studies described above that a preferable placement was such that at least a plurality of collector apertures of a thin film photovoltaic were distributed uniformly in the overlap region in which the unit photoelectric conversion section and the unit back electrode section which formed each unit cell overlapped each other. More specifically, the plurality of collector apertures are placed in a lattice form or a staggered form in such a manner that those collector apertures which are located most closely to each other are equally spaced from each other. Whether in the lattice form or in the staggered form the plurality of collector apertures are to be placed can be appropriately chosen to meet the number of collector apertures or the size and shape of the region allowing the collector apertures to be placed therein. With the collection loss taken into consideration, it can be said to be more preferable that the collector apertures are placed in such a manner that the distance from each of the opposite ends of the unit photoelectric conversion section to those collector apertures which are located most closely thereto is equal to or less than the spacing between those collector apertures which are located most closely to each other.

While the foregoing studies were made on the methods of placing collector apertures in the region allowing the collector apertures to be placed therein (i.e., rectangular region A) which was sized 195.6 mm × 26.8 mm, a specific optimal placement of collector aperture can be found out by the above-described series of studies even when the region allowing the collector apertures to be placed therein is different in shape or size from that in the foregoing studies. Though the optimal row number of collector apertures and the optimal aperture ratio (i.e., the optimal number of collector apertures) vary with change in the shape or size of the region allowing the collector apertures to be placed therein, it can be considered from the above-described studies that the effect that the conversion efficiency can be improved by the placement in which a plurality of collector apertures are distributed in the second overlap region (i.e., rectangular region A) which allows the collector apertures to be placed therein while those collector apertures which are located most closely to each other are equally spaced from each other, remains the same.

In the thin film photovoltaic having the SCAF structure, the change in the shape or size of the region allowing the collector apertures to be placed therein includes not only a simple change in shape or size, but also changes in relation to the connection apertures and their peripheral regions (i.e., mask regions) and changes in the shape of the first line-like removed portions and in the shape of the second line-like removed portions. Since the thin film photovoltaic having the SCAF structure has the region allowing the collector apertures to be placed therein which can be thus changed by the presence of the connection apertures and the presence of the first and second line-like removed portions, an optimal placement of collector apertures has to be determined by simulations conducted taking such conditions into consideration. It is needless to say that the size and number of the connection apertures are preferably established with the area loss incurred by the presence of the connection apertures and the resistance loss at the connection apertures taken into consideration.

While the foregoing description has been directed to the thin film photovoltaic having a plurality of unit cells formed on a single insulating substrate, there is no limitation to this arrangement. For example, unlike the arrangement in which the plurality of unit cells are formed on the single insulating substrate, an alternative arrangement is possible in which a plurality of unit cells are formed on a plurality of insulating substrates. This means that the scope of the present invention encompasses any thin film photovoltaic that has a structure in which a plurality of unit cells are connected in series.

### EXPLANATION OF REFERENCE NUMERALS

10 thin film photovoltaic, 11 insulating substrate, 12 first electrode layer, 13 photoelectric conversion layer, 14 second electrode layer (transparent electrode layer), 15 photoelectric conversion section, 16 third electrode layer, 17 fourth electrode layer, 18 back electrode layer, 18a projecting portion, 19 collector aperture, 20 connection aperture, 21 first line-like removed portion, 22 second line-like removed portion, 22a bend portion, UC unit cell (unit photovoltaic)

## Claims

1. A thin film photovoltaic comprising a plurality of unit photovoltaic cells each having a photoelectric conversion section in which a first electrode layer, a photoelectric conversion layer and a transparent second electrode layer are stacked sequentially on a front side of an insulating substrate, and a back electrode layer stacked on a reverse side of the insulating substrate,
the unit photovoltaic cells being arranged in such a manner that two adjacent unit photovoltaics cells define therebetween a first overlap region in which a portion of the first electrode layer which does not form the photoelectric conversion section of one of the two adjacent unit photovoltaic cells and a portion of the back electrode layer of the other unit photovoltaic are opposed to each other across the insulating substrate, and
the plurality of unit photovoltaic cells being connected in series by an arrangement such that in each of the unit photovoltaic cells, the second electrode layer and the back electrode layer are electrically connected to each other through a plurality of connection holes extending through the insulating substrate while the first electrode layer of one of the two adjacent unit photovoltaic cells and the back electrode layer of the other unit photovoltaic are electrically connected to each other through at least one connection aperture extending through the insulating substrate in the first overlap region,
wherein the plurality of collector apertures are placed in such a manner that the current collection holes are distributed in a second overlap region in which the photoelectric conversion section and the back electrode layer which form each of the unit photovoltaic cells are opposed to each other across the insulating substrate while those collector apertures which are placed most closely to each other are equally spaced from each other.

2. The thin film photovoltaic according to claim 1, wherein at least one of the first electrode layer and the back electrode layer in each of the unit photovoltaic cells has a bend portion defining the first overlap region on an adjacent unit cell side, while a whole or a major part of the photoelectric conversion section is opposed to the back electrode corresponding thereto across the insulating substrate.
